# EUROPÄISCHE PATENTSCHRIFT

(11) **EP 4 264 832 B1**
(45) Veröffentlichungstag und Bekanntmachung des Hinweises auf die Patenterteilung: **15.10.2025**
(21) Anmeldenummer: 21823779.0
(22) Anmeldetag: 24.11.2021
(51) Int. Cl.: H03K 17/16

(54) **TREIBERSCHALTUNG UND VERFAHREN ZUR ANSTEUERUNG EINES HALBLEITERSCHALTERS**
DRIVER SWITCH AND METHOD FOR CONTROLLING A SEMICONDUCTOR CIRCUIT
CIRCUIT D'ATTAQUE ET PROCÉDÉ DE COMMANDE D'UN INTERRUPTEUR À SEMI-CONDUCTEUR

(30) Priorität: 16.02.2021 EP 21157318
(43) Veröffentlichungstag der Anmeldung: 25.10.2023
(73) Patentinhaber: Siemens Aktiengesellschaft, 80333 München (DE)
(72) Erfinder: NEUMEISTER, Matthias, 91058 Erlangen (DE); PFEIFER, Markus, 90455 Nürnberg (DE)
(74) Vertreter: Siemens Patent Attorneys
(86) Internationale Anmeldenummer: PCT/EP2021/082842
(87) Internationale Veröffentlichungsnummer: WO 2022/174948

(56) Entgegenhaltungen:
- EP-A1- 3 270 513
- EP-A2- 1 282 230
- US-A- 5 926 012
- US-A1- 2010 019 808
- US-A1- 2012 182 051
- US-A1- 2015 318 848

## Beschreibung

Beim Ausschalten von Halbleiterschaltern wie IGBTs treten aufgrund von angeschlossenen Induktivitäten Ausschaltüberspannungen auf. Bei den angeschlossenen Induktivitäten kann es sich sowohl um induktive Bauelemente wie auch um Streuinduktivitäten, also parasitäre Elemente wie beispielsweise Leitungsinduktivitäten handeln. Die sich ergebenden Ausschaltüberspannungen können höher als die maximal zulässige Sperrspannung des Halbleiterschalters sein und damit seine Lebensdauer verringern oder ihn im Extremfall sogar direkt zerstören.

Da die Höhe der Ausschaltüberspannungen unter anderem von der Geschwindigkeit des Abschaltens beeinflusst wird, fallen die Ausschaltüberspannungen bei neueren IGBT-Generationen stärker ins Gewicht, da diese Bauelemente auf schnelleres Schalten ausgelegt werden. Schnelles Schalten wird dabei generell bevorzugt, da damit die auftretenden Schaltverluste verringert werden.

Es ist bekannt, zu hohe Ausschaltüberspannungen anhand der zeitlichen Ableitung des Kollektorstroms (dI_{c}/dt) oder anhand der zeitlichen Ableitung der Kollektor-Emitter-Spannung (dU_{CE}/dt) zu detektieren. Diese Detektion kann direkt in der Treiberschaltung des Halbleiterschalters erfolgen und Gegenmaßnahmen wie ein zeitweises Wiedereinschalten des Halbleiterschalters können ebenfalls direkt dort getroffen werden. Dadurch werden die Gegenmaßnahmen schnell umgesetzt. Bei früheren Generationen von IGBTs war dadurch eine ausreichende Reaktionsgeschwindigkeit verfügbar, um in der verbleibenden Zeit von - grob - 1 µs nach einer der beschriebenen Messmethoden eine Gegenmaßnahme einzuleiten und eine Beschädigung des Halbleiterschalters zu verhindern.

Bei modernen Halbleiterschaltern ist aber bedingt durch deren hohe Schaltgeschwindigkeit die nach einer der oben beschriebenen Messmethoden verbleibende Zeit, um Gegenmaßnahmen einzuleiten, kürzer als bisher und kann im Bereich von weniger als 100 ns liegen. Diese Zeit kann selbst bei einer Reaktion in der Treiberschaltung zu gering sein, um sicher eine Beschädigung des Halbleiterschalters ausschließen zu können. Als generelle Gegenmaßnahme kann das Ausschalten zwar unabhängig von der konkreten Situation des Halbleiterschalters verzögert werden, das ist aber sehr unattraktiv, da damit der Vorteil des schnellen Schaltens, nämlich die Verringerung der Schaltverluste, negiert wird.

Treiberschaltungen sind aus der US 2012/0182051 A1 sowie die EP 3270513 A1 bekannt.

Es ist Aufgabe der vorliegenden Erfindung, eine Treiberschaltung für einen Halbleiterschalter anzugeben, die die eingangs genannten Nachteile vermeidet, also eine verbesserte Reaktion auf eine möglicherweise zu hohe Ausschaltspannung ermöglicht. Eine weitere Aufgabe besteht darin, ein entsprechendes Betriebsverfahren für einen Halbleiterschalter anzugeben.

Diese Aufgabe wird durch eine Treiberschaltung mit den Merkmalen von Anspruch 1 gelöst. Hinsichtlich des Betriebsverfahrens besteht eine Lösung in dem Verfahren mit den Merkmalen von Anspruch 15. Die Unteransprüche betreffen vorteilhafte Ausgestaltungen der Treiberschaltung bzw. des Verfahrens.

Die erfindungsgemäße Treiberschaltung zur Ansteuerung eines Halbleiterschalters umfasst einen Kontakt zur Verbindung mit einem Steueranschluss (Gate-Anschluss) des Halbleiterschalters. Sie umfasst weiterhin eine Vorrichtung in Form einer Schaltung, die ausgestaltet ist, im Zuge eines Abschaltvorgangs des Halbleiterschalters eine Messung eines von der Höhe des durch den Schalter fließenden Stroms abhängigen Werts vorzunehmen.

Je nach konkretem Halbleiterschalter ist der durch den Schalter fließende Strom der Kollektorstrom oder der Drainstrom.

In einer ersten Alternative ist dieser Wert die Höhe des Gatestroms zu einem Zeitpunkt nach Beginn des Abschaltvorgangs.

In einer zweiten Alternative ist dieser Wert eine Zeitspanne vom Beginn des Abschaltvorgangs bis zum Erreichen eines festlegbaren Schwellwerts der über den Halbleiterschalter abfallenden Spannung. Je nach konkretem Halbleiterschalter wird die Spannung als Kollektor-Emitter-Spannung oder Source-Drain-Spannung bezeichnet.

Die Vorrichtung ist weiterhin ausgestaltet, in Abhängigkeit von der Größe des Werts eine Steuermaßnahme zur Verringerung der zeitlichen Änderung des durch den Halbleiterschalter fließenden Stroms vorzunehmen. Dabei ist mit der Verringerung eine Verringerung des Betrags der zeitlichen Änderung gemeint, also eine Verlangsamung der Strom-Änderung unabhängig von ihrer Richtung.

Bei dem erfindungsgemäßen Verfahren zur Ansteuerung eines Halbleiterschalters wird im Zuge eines Abschaltvorgangs des Halbleiterschalters eine Messung eines von der Höhe des Kollektorstroms abhängigen Werts vorgenommen. In einer ersten Alternative ist dieser Wert die Höhe des Gatestroms zu einem Zeitpunkt nach Beginn des Abschaltvorgangs. In einer zweiten Alternative ist dieser Wert eine Zeitspanne vom Beginn des Abschaltvorgangs bis zum Erreichen eines festlegbaren Schwellwerts der Kollektor-Emitter-Spannung. In Abhängigkeit von der Größe des Werts wird eine Steuermaßnahme zur Verringerung der Kollektorstrom-Änderung vorgenommen.

Der Beginn eines Abschaltvorgangs wird in einer ersten Alternative anhand eines Schwellwerts für die Gatespannung festgelegt. Beispielsweise kann bei einer typischen Beschaltung des Gate-Kontakts ein Unterschreiten einer Gatespannung von 14 V als Trigger verwendet werden, um den Beginn des Abschaltvorgangs festzulegen.

Der Beginn eines Abschaltvorgangs wird in einer zweiten Alternative anhand eines Steuerbefehls der übergeordneten Steuerung festzulegen.

In einer weiteren Alternative wird der Beginn eines Abschaltvorgangs anhand des Werts einer Steuerspannung festzulegen, wobei die Steuerspannung ein Spannungswert zwischen einer Endstufe der Treiberschaltung und einem Gatewiderstand ist.

Vorteilhaft liegen die Zeitpunkte, zu denen mit dem erfindungsgemäßen Verfahren und der erfindungsgemäßen Treiberschaltung eine Messung vorliegt, die eine Aussage über das Auftreten einer zu großen Abschalt-Überspannung vorliegt, deutlich vor denjenigen, die mit bekannten Methoden erreichbar sind. Beispielsweise kann die dU_{CE}/dt-Messung erst etwa dann erfolgen, wenn die Kollektor-Emitter-Spannung schon auf etwa die Hälfte der Nennspannung angestiegen ist. Dagegen kann in der zweiten Alternative der Schwellwert auf einen deutlich geringeren Wert festgelegt werden.

Die Erfindung ermöglicht also eine deutlich frühere Erkennung eines hohen Kollektor-Stroms und erlaubt daher auch bei sehr schnell schaltenden Halbleiterschaltern eine Reaktion auf einen zu hohen Kollektor-Strom.

Vorteilhafte Ausgestaltungen der erfindungsgemäßen Treiberschaltung und des erfindungsgemäßen Verfahrens gehen aus den von Anspruch 1 abhängigen Ansprüchen hervor. Dabei kann die Ausführungsform nach Anspruch 1 mit den Merkmalen eines der Unteransprüche oder vorzugsweise auch mit denen aus mehreren Unteransprüchen kombiniert werden. Demgemäß können noch zusätzlich folgende Merkmale vorgesehen werden:

Die Vorrichtung kann ausgestaltet sein, als Steuermaßnahme ein temporäres Wiedereinschalten des Halbleiterschalters vorzunehmen. Ebenso kann die Vorrichtung ausgestaltet sein, als Steuermaßnahme eine Änderung der Gatespannung vorzunehmen. Weiterhin kann die Vorrichtung ausgestaltet sein, als Steuermaßnahme ein Umschalten auf einen höheren Gatewiderstand vorzunehmen. Die genannten Maßnahmen führen dazu, dass der Kollektor-Strom zumindest für einen kurzen Zeitraum weniger stark absinkt oder sogar wieder steigt. Die Kollektor-Emitter-Spannung steigt dementsprechend weniger stark an oder fällt für den kurzen Zeitraum. Dieser Zeitraum steht für den weiteren Abbau der induktiv gespeicherten Energie zur Verfügung und sorgt damit für eine Verringerung der entstehenden Überspannung, wenn der Halbleiterschalter in der Folge endgültig abgeschaltet wird.

Die Vorrichtung kann ausgestaltet sein, in Abhängigkeit von der Größe des Werts ein Signal an eine übergeordnete Steuerung zu geben. Dadurch wird erreicht, dass die übergeordnete Steuerung des Geräts, von dem der Halbleiterschalter ein Teil ist, also beispielsweise ein Umrichter, reagieren kann. So kann beispielsweise auf den Eingang eines solchen Signals mit einem Notbetrieb reagiert werden.

Die Vorrichtung kann ausgestaltet sein, bei einem ersten Abschaltvorgang den gemessenen Wert zu speichern und bei einem folgenden Abschaltvorgang, insbesondere dem nächstfolgenden Abschaltvorgang, eine Differenz des in dem folgenden Abschaltvorgang gemessenen Werts und des gespeicherten Werts zu ermitteln und ein Wiedereinschalten des Halbleiterschalters basierend auf der Differenz zu steuern. Dadurch wird erreicht, dass eine Kalibrierung auf die Eigenschaften des spezifischen Halbleiterschalters unnötig ist. Die Exemplarstreuung der Halbleiterschalter könnte ansonsten dazu führen, dass die Treiberschaltung an den einzelnen Schalter angepasst werden muss. Weiterhin wird vorteilhaft erreicht, dass der Einfluss anderer Störgrößen wie beispielsweise der Temperatur unerheblich wird, selbst wenn dieser Einfluss erheblich oder sogar überwiegend ist gegenüber dem Einfluss des Kollektor-Stroms auf den gemessenen Wert. Voraussetzung ist, dass die Störgrößen nur eine geringfügige Veränderung zwischen zwei aufeinanderfolgenden Abschaltvorgängen aufweisen. Da aber die Abschaltvorgänge mit Frequenzen von 10 kHz oder mehr aufeinander folgen, ist das für die Temperatur erfüllt.

Alternativ kann die Vorrichtung ausgestaltet sein, einen Ergebniswert unter Verwendung des gemessenen Werts und einer gespeicherten Wertetabelle zu ermitteln und aus dem Ergebniswert die Steuermaßnahme abzuleiten. In diesem Fall wird also nicht eine relative Bestimmung vorgenommen wie bei dem Vergleich mit einem vorangegangenen Messwert, sondern eine absolute Bestimmung des Ergebnisses. Dafür muss aber eine Wertetabelle vorliegen. Es ist zweckmäßig, wenn diese Wertetabelle auch andere Einflussgrößen beinhaltet wie beispielsweise die Temperatur. Entsprechend müssen diese Einflussgrößen auch zusammen mit dem gemessenen Wert in die Tabelle eingespielt werden, um ein momentanes Ergebnis zu erhalten.

Die Vorrichtung kann ausgestaltet sein, als Schwellwert der Kollektor-Emitter-Spannung höchstens 10 % der Nennspannung des Halbleiterschalters zu verwenden, insbesondere höchstens 5 %. Wird ein solch kleiner Wert verwendet, endet der Messzeitraum früher und der Wert steht früher zur Verfügung. Der Zeitraum, der für eine Reaktion auf einen möglichen zu hohen Kollektor-Strom bleibt, wird dadurch vergrößert.

Die Vorrichtung kann ausgestaltet sein, einen Zeitraum, in dem die Vornahme der Steuermaßnahme möglich ist, mittels einer Verzögerungsschaltung festzulegen. Beispielsweise kann ein Ausgangssignal, das die Steuermaßnahme auslöst, außerhalb dieses Zeitraums durch einen Halbleiterschalter geerdet werden. Der Zeitraum selbst wird anhand eines anderen Signals begonnen und durch eine beispielsweise schaltungstechnisch festgelegte Verzögerung beendet. Diese schaltungstechnisch festgelegte Verzögerung kann beispielsweise durch ein RC-Glied mit nachfolgendem Schmitt-Trigger bestimmt werden.

Alternativ kann die Vorrichtung ausgestaltet sein, einen Zeitraum, in dem die Vornahme der Steuermaßnahme möglich ist, mittels einer Spannungsmessung an einer Z-Diode festzulegen, die mittels eines Spannungsteilers an die Kollektor-Emitter-Spannung angeschlossen ist. Diese Spannungsmessung hat sich in Versuchen als vorteilhaft ergeben, da der Aufbau sehr einfach ist und im Zeitraum des Anstiegs der Kollektor-Emitter-Spannung ein deutlich ausgeprägtes Spannungsplateau erzeugt, durch das der Zeitraum eines sinnvollen Eingriffs in den Abschaltvorgang sehr genau abgegrenzt werden kann.

Die Treiberschaltung bzw. das Verfahren können vorteilhaft in einer Schaltung mit einem Halbleiterschalter wie beispielsweise einem IGBT-Schalter verwendet werden. Die Erfindung ist nicht auf IGBTs beschränkt, sondern kann gleichermaßen bei MOSFETs, insbesondere Silziumkarbid (SiC)-basierten MOSFETs zur Anwendung kommen. In bekannter Weise sind dann Bezugnahmen auf Kollektor als Drain zu verstehen und Bezugnahmen auf Emitter als Source zu verstehen.

Weitere Vorteile und Merkmale sind der folgenden Beschreibung von Ausführungsbeispielen anhand der Figuren zu entnehmen. In den Figuren bezeichnen gleiche Bezugszeichen gleiche Bauteile und Funktionen.

Es zeigen:
Figur 1 ein Blockschaltbild eines IGBT mit einer Treiberschaltung und einer mit der Treiberschaltung verbundenen übergeordneten Steuerung,
Figur 2 ein Diagramm mit stark schematisierten Strom- und Spannungsverläufen bei einem Abschaltvorgang des IGBTs,
Figur 3 ein Diagramm mit Messergebnissen zur Kollektor-Emitter-Spannung bei verschiedenen Kollektor-Strömen,
Figur 4 ein Blockschaltbild einer ersten Teilschaltung einer Treiberschaltung, bei der die Verzugszeit ausgewertet wird,
Figur 5 ein Blockschaltbild einer zweiten Teilschaltung der Treiberschaltung,
Figur 6 ein Diagramm mit Schaltzuständen des IGBT und Schaltern der Teilschaltungen,
Figur 7 ein Diagramm mit Messergebnissen zum Gate-Strom bei verschiedenen Kollektor-Strömen,
Figur 8 ein Blockschaltbild einer Teilschaltung der Treiberschaltung,
Figur 9 ein Blockschaltbild einer weiteren Teilschaltung.

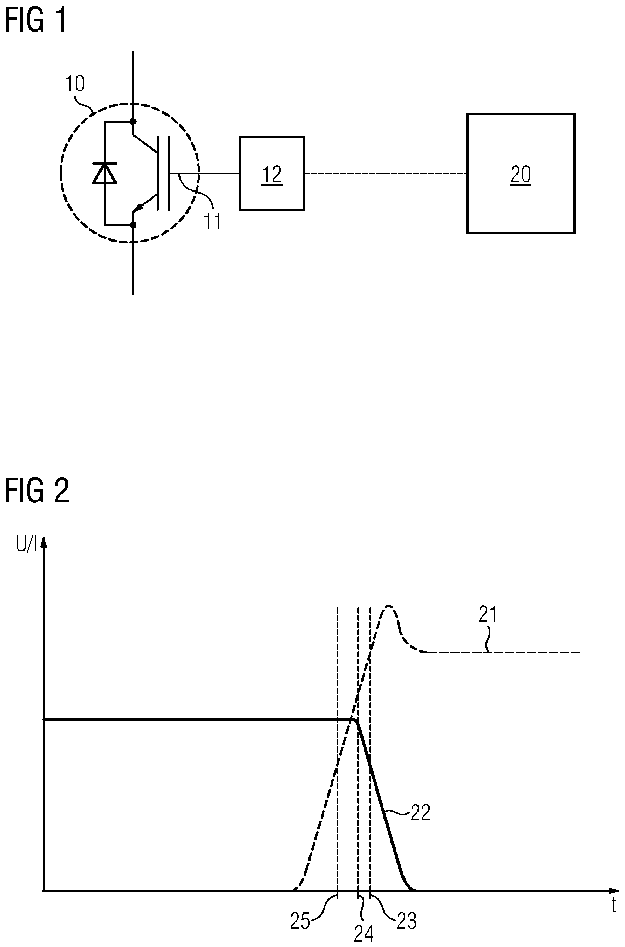

Figur 1 zeigt ein Blockschaltbild eines Schaltungsteils, das einen IGBT 10 umfasst. Der IGBT 10 steht beispielhaft für alle Halbleiterschalter, für die die Erfindung angewendet werden kann. Der IGBT 10 kann Teil einer Schaltung sein, die beispielsweise eine Halbbrücke oder einen Umrichter ausbildet. Der IGBT 10 ist dazu mit weiteren IGBTs oder anderen Halbleiterschaltern verbunden und wird von einer übergeordneten Steuerung 20 angesteuert, um den Zweck der Schaltung zu verwirklichen. Dazu wird der IGBT 10 beispielsweise mit einer Pulsweitenmodulation mit einer Frequenz von 10 kHz geschaltet.

Die hardwarenahe Ansteuerung des IGBTs 10, also die Beaufschlagung seines Gate-Anschlusses 11 mit Spannung und Strom wird von einem Treiber 12 vorgenommen. Der Treiber 12 ist dazu einerseits mit dem Gate-Anschluss 11 des IGBT 10 verbunden und andererseits mit der Steuerung 20. Neben der Umsetzung von Steuersignalen der Steuerung 20 kommt dem Treiber 12 auch die Aufgabe zu, Vorgänge zu steuern, die einen derart schneller Eingriff erfordern, dass eine Rückmeldung an die Steuerung 20 und ein Abwarten auf Steuersignale von dort zu lange dauern würde. Zu diesen Aufgabe gehört eine Reaktion auf eine mögliche Überspannung, die sich bei einem Abschaltvorgang des IGBT 10 über den IGBT 10 einstellt. Der Grund für eine solche Überspannung liegt in induktiv gespeicherter Energie, die der Stromänderung im Zuge der Abschaltung entgegenwirkt und je nach konkreter Gestaltung der Schaltung, beispielsweise vorhandenen Kapazitäten, und Größe der gespeicherten Energie zu höherer oder geringerer Überspannung führt. Überschreitet die über den IGBT 10 anliegenden Spannung dessen Sperrfähigkeit, kann das zu seiner Schädigung oder Zerstörung führen.

Ist die Abschaltgeschwindigkeit, d.h. die zeitliche Änderung des Stroms nicht allzu hoch verglichen mit der Zeit, in der sich die induktiv erzeugte Überspannung selbsttätig abbaut, bleibt auch die sich ergebende Überspannung gering. Moderne IGBTs werden jedoch auf immer schnellere Schaltvorgänge hin optimiert, um die auftretenden Schaltverluste zu verringern. Ein pauschales künstliches Verlängern der Abschaltzeit wirkt dieser Verbesserung entgegen und kommt daher normalerweise nicht in Frage. Die Abschaltgeschwindigkeit wird daher in bekannten Treiberschaltungen durch ein situationsabhängiges, kurzes Wiedereinschalten des IGBTs 10 wenn nötig auf Werte begrenzt, die eine schädigende Überspannung vermeiden.

Um situationsabhängig einschalten zu können, muss die sich abzeichnende Überspannung detektiert werden. In bekannten Treiberschaltungen geschieht dies beispielsweise durch die Messung von dU_{CE}/dt, also der zeitlichen Änderung der Kollektor-Emitter-Spannung oder dI_{C}/dt, also der zeitlichen Änderung des Kollektor-Stroms. Diese Messungen sind erst möglich, wenn die jeweiligen Änderungen im Zuge des Abschaltvorgangs auftreten und dann auch groß genug sind, um verlässliche Messungen zu erlauben. Das ist erst etwa in der Mitte der Abschaltreaktion, also der tatsächlichen Anfalls des Stroms bzw. des tatsächlichen Anstiegs der Kollektor-Emitter-Spannung möglich. Zu deren Ende hin ergibt sich bereits die Überspannung, sofern eine solche auftritt. Figur 2 zeigt einen stark schematisierten und vereinfachten Abschaltvorgang für einen beliebigen IGBT. Dabei ist der Spannungs-Verlauf 21 der Kollektor-Emitter-Spannung und der Stromverlauf 22 des Kollektor-Stroms gezeigt. Die Überspannung ergibt sich ab dem Zeitpunkt 23, wie am Spannungs-Verlauf 21 erkennbar ist. Eine Messung der Stromänderung dI_{C}/dt ist zum Zeitpunkt 24 möglich, der nur geringfügig vor dem Einsetzen der Überspannung liegt. Eine Messung der Spannungsänderung dU_{CE}/dt ist zum Zeitpunkt 25 möglich. Der Zeitpunkt 25 liegt noch etwas vor dem Zeitpunkt 24 und gibt demnach noch etwas mehr Zeit bis zum Einsetzen der Überspannung zum Zeitpunkt 23.

Je nach Schaltgeschwindigkeit des betrachteten IGBTs kann die Zeit, die für eine Reaktion verbleibt, also der Abstand zwischen dem Zeitpunkt 23 und einem der Zeitpunkte 24, 25 im Bereich von µs betragen und ausreichend sein, um die Geschwindigkeit der Stromänderung durch eine Schalthandlung des Treiber 12 zu begrenzen. Bei besonders schnellen IGBTs kann die Zeit, die für eine Reaktion verbleibt, aber auch im Bereich von nur noch 100 ns betragen. Diese Zeit ist selbst für den Treiber 12 zu gering für eine Reaktion, da für ein Umsteuern des IGBTs in einem solchen Zeitrahmen selbst die geringen parasitär vorhandenen Induktivitäten zu hoch sind.

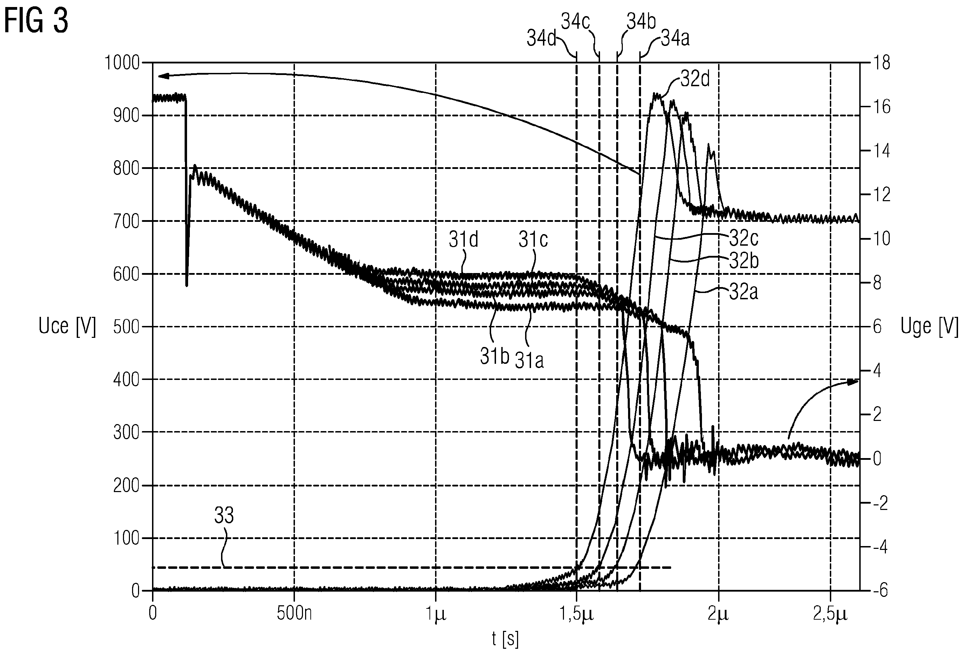

In einem ersten Ausführungsbeispiel für die Erfindung führt der Treiber 12 daher eine veränderte Messung durch. Diese Messung basiert auf der Erkenntnis, dass die Verzugszeit, die sich vom Beginn eines Abschaltvorgangs bis zum Erreichen einer bestimmten Spannungshöhe der Kollektor-Emitter-Spannung erstreckt, von der Höhe des Kollektor-Stroms abhängt. Dieser Zusammenhang ist in Figur 3 verdeutlicht. Figur 3 zeigt eine Messreihe zu Schaltvorgängen eines IGBT bei verschiedenen Werten für den Kollektor-Strom. Die Messkurven 31a...d zeigen den Verlauf der Gate-Emitter-Spannung U_{GE} während eines Abschaltvorgangs, der in etwa 2 µs dauert. Die Messkurve 31a ist bei einem Kollektor-Strom von I_{C} = 225 A aufgenommen und die Messkurve 31d bei einem Kollektor-Strom von I_{C} = 850 A. Die zugehörigen Verläufe 32a...d der Kollektor-Emitter-Spannung U_{CE} sind ebenfalls aufgetragen.

Dabei ist erkennbar, dass bei exakter Übereinstimmung des Beginns des Abschaltvorgangs bei ca. t = 100 ns der Anstieg der Kollektor-Emitter-Spannung U_{CE} bei verschiedenen Kollektor-strömen I_{C} zeitlich verschoben ist. Wird der Zeitpunkt betrachtet, zu dem die Kollektor-Emitter-Spannung U_{CE} einen Schwellwert 33, beispielsweise 50 V erreicht, ergeben sich vier verschiedene Zeitpunkte 34a...d, deren Lage also direkt vom Kollektor-Strom I_{C} abhängt. Aus dieser zeitlichen Lage lässt sich also der Kollektor-Strom I_{C} ermitteln. Aus der Höhe des Kollektorstroms wiederum kann darauf geschlossen werden, ob ein Fehler vorliegt und durch einen zu hohen Kollektor-Strom I_{C} bedingt auch eine zu hohe Überspannung zu erwarten ist.

Vorteilhaft kann hierbei der Schwellwert 33 vergleichsweise gering gewählt werden, beispielsweise nur 20% oder auch nur 10% oder sogar 5% der Nennspannung. Bei einer Messung von dU_{CE}/dt hingegen ist ein brauchbarer Wert erst erreichbar, wenn die Spannung U_{CE} auf etwa die Hälfte der Nennspannung angestiegen ist, also später. Es ergibt sich also durch die Auswertung der Verzugszeit bis zum Erreichen des Schwellwerts 33 eine schnellere Messung und dadurch eine vergrößerte Reaktionszeit für Gegenmaßnahmen.

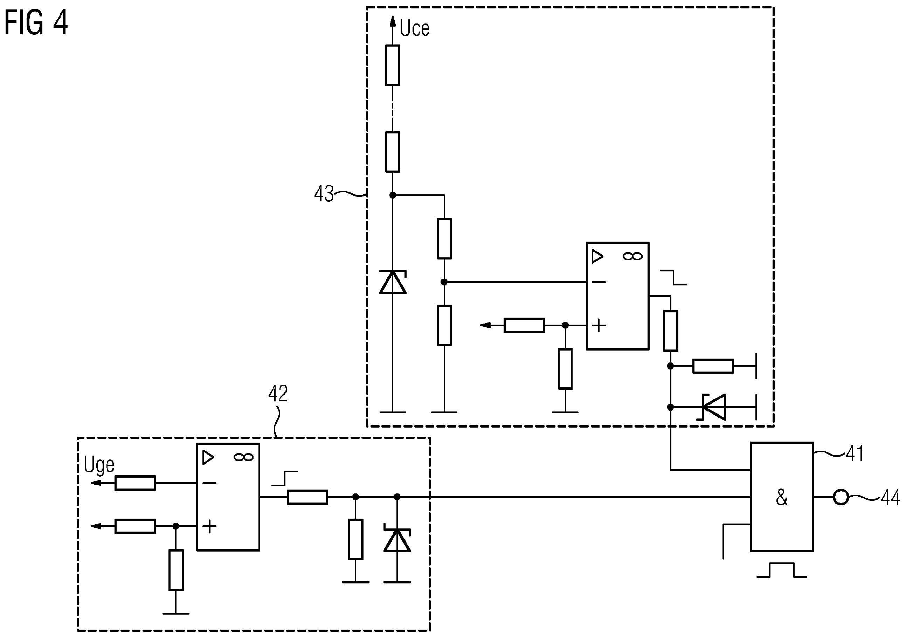

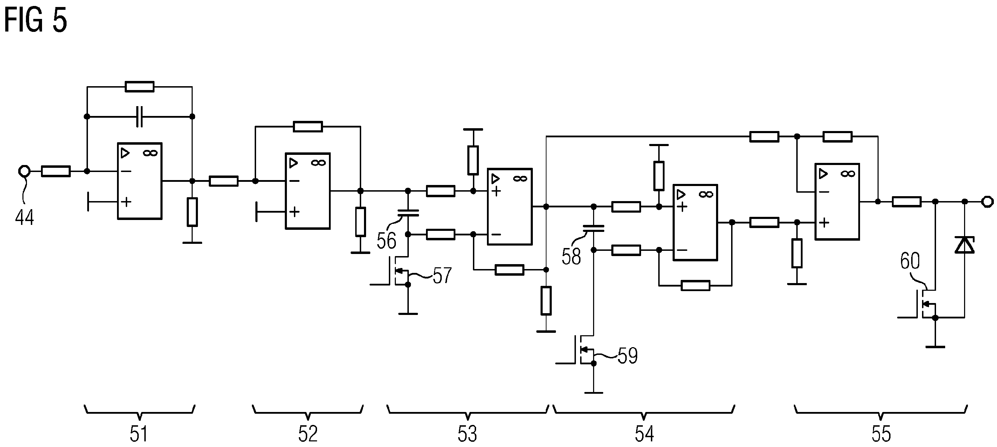

Eine beispielhafte und vereinfachte Darstellung einer Schaltung zur Auswertung der Verzugszeit ist in den Figuren 4 und 5 gegeben. Dabei ist die Schaltung in beiden Figuren mit Operationsverstärkern aufgebaut, damit die einzelnen Funktionsblöcke der Schaltung gut erkennbar sind. In einer realen Schaltung würden diese typischerweise durch einfachere Halbleiterschalter ersetzt und der Aufbau vereinfacht und verkleinert.

Eine Erkennung einer auftretenden Verzugszeit passiert mit der Teilschaltung der Figur 4. Dabei wird ein AND-Gatter 41 von drei Eingangssignalen gespeist. Ein erstes Eingangssignal dient der Erkennung eines Abschaltvorgangs durch einen Komparator 42, mit dem ein Abfall der Gate-Emitter-Spannung U_{GE} detektiert wird. Die Gate-Emitter-Spannung U_{GE} ist dabei an den invertierenden Eingang geschaltet, sodass eine steigende Flanke erzeugt wird, sobald die Gate-Emitter-Spannung U_{GE} unter die Referenzspannung fällt.

Ein zweites Eingangssignal wird durch eine Auswertung der Kollektor-Emitter-Spannung U_{CE} erzeugt. Die Kollektor-Emitter-Spannung U_{CE} wird dabei mit dem in Figur 3 eingeführten Schwellwert 33 in einem zweiten Komparator 43 verglichen. Dafür ist die Kollektor-Emitter-Spannung U_{CE} über einen geeigneten Spannungsteiler mit dem invertierenden Eingang eines Operationsverstärkers verbunden. Steigt die Kollektor-Emitter-Spannung U_{CE} über den Referenzwert, ergibt sich also eine fallende Flanke als Eingangssignal für das AND-Gatter.

Ein drittes Eingangssignal wird aus einem Treiberansteuerimpuls abgeleitet. Dies ist notwendig, da beim Einschalten des IGBT ebenfalls eine Kombination der beiden anderen Eingangssignale auftreten kann, die der Verzugszeitmessung entspricht. Dieser Vorgang wird durch das dritte Eingangssignal aber ausgeblendet.

Die Kombination der Eingangssignale ergibt generell einen Ausgangswert auf Low-Niveau. Nur während des Zeitraums, der der Verzugszeit entspricht, also bei einem Abschaltvorgang zwischen dem initialen Abfall der Gate-Emitter-Spannung U_{GE} und dem Anstieg der Kollektor-Emitter-Spannung U_{CE}, ergibt sich ein High-Niveau am Ausgang des AND-Gatters. Mit diesem Ausgangssignal kann die weitere Verarbeitung in der Teilschaltung gemäß Figur 5 erfolgen. Die Verbindung der Teilschaltungen erfolgt dabei am Knotenpunkt 44.

Die Teilschaltung der Figur 5 lässt sich grob in fünf Blöcke unterteilen. Ein erster Block 51 stellt dabei einen Integrator dar. Der Integrator wandelt die Dauer des Ausgangssignals des AND-Gatters 41 in einen Spannungswert um, dessen Höhe also ein Maß für die Verzugszeit darstellt. Diese Spannungshöhe ist über einen invertierenden Verstärker 52 an einen Differenzverstärker 53 geschaltet. Zwischen dem invertierenden Verstärker 52 und dem Differenzverstärker ist ein Kondensator 56 und ein MOSFET 57 angeordnet. Der Kondensator 56 dient dem Halten eines aktuellen Werts für die Verzugszeit. Über den MOSFET 57, der zu einem Erdpotential verbunden ist, kann ein Laden des Kondensators ermöglicht oder blockiert werden.

Ausgangsseitig ist der Differenzverstärker 53 mit einem zweiten Differenzverstärker 54 verbunden. Zwischen den beiden Differenzverstärkern ist eine weitere Schaltung eines zweiten Kondensators 58 und eines zweiten MOSFETs 59 angeordnet, die analog zu dem ersten Kondensator und MOSFET 56, 57 angeordnet sind. Der zweite Kondensator dient einer Speicherung eines vorherigen Werts für die Verzugszeit und seine Aufladung kann über den zweiten MOSFET 59 gesteuert werden.

Schließlich ist ein dritter Differenzverstärker 55 an die Ausgänge der beiden vorherigen Differenzverstärker 53, 54 geschaltet. Der dritte Differenzverstärker 55 nimmt somit einen Vergleich der beiden in den Kondensatoren 56, 58 gespeicherten Verzugszeitwerte vor. Ein dritter MOSFET 60 ist dabei so an den Ausgang geschaltet, dass die Ausgabe eines Steuerimpulses durch die Schaltung der Figur 5 an den IGBT 10 nur zu bestimmten Zeitpunkten zugelassen wird.

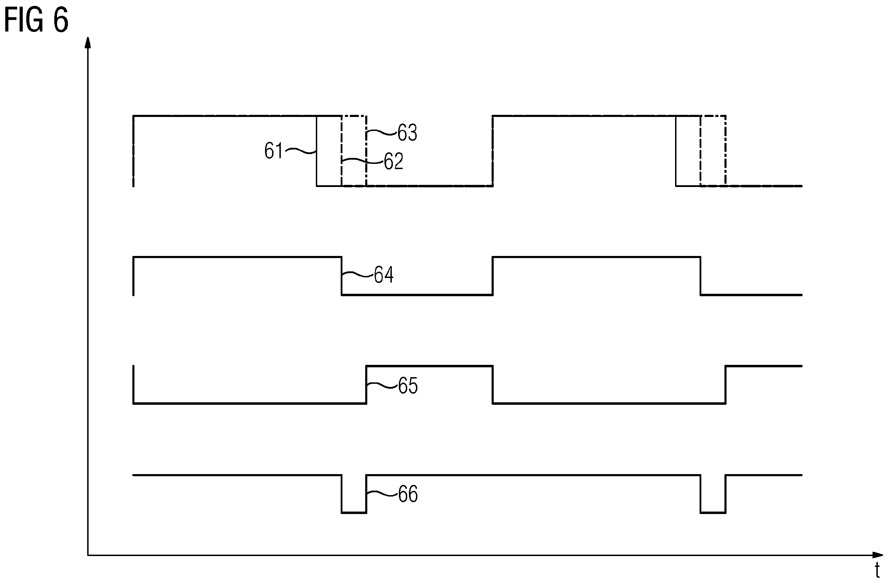

Figur 6 zeigt einen schematischen zeitlichen Verlauf der Schaltimpulse über einen Zeitraum von zwei An- und Ausphasen des IGBT 10. Der Schaltzustand des IGBT 10 ist dabei als Verlauf 61 gezeigt, wobei hier der Ansteuerimpuls für den IGBT 10 gemeint ist. Die für den Treiber 12 relevanten Zeiten sind die beiden Ausschaltflanken des Verlaufs 61. Der am Knotenpunkt 44 anliegende Verlauf 62 ist überlappend mit dem Verlauf 61 dargestellt und zeigt den zeitlichen Bereich der Verzugszeit, bis also die Kollektor-Emitter-Spannung U_{CE} den verwendeten Schwellwert erreicht hat. Bis zu diesem Ende ist der erste MOSFET 57 angeschaltet und das Laden des ersten Kondensators 56 erlaubt; die Verzugszeit wird also eingespeichert. Bei Ende der Verzugszeit wird der erste MOSFET 57 abgeschaltet und am Eingang des dritten Differenzverstärkers 55 liegen die aktuelle und die vorherige Verzugszeit als die Spannungswerte von erstem und zweitem Kondensator 56, 58 an. Ab diesem Zeitpunkt erlaubt der dritte MOSFET 60 die Weitergabe eines Steuerimpulses, indem er abgeschaltet wird.

Nach dem Abschaltvorgang wird der zweite MOSFET 59 eingeschaltet und erlaubt somit eine Weitergabe (Auf- oder Entladung) der aktuellen Verzugszeit in den zweiten Kondensator 58, womit die aktuelle Verzugszeit zur vorherigen Verzugszeit für den nächsten Abschaltvorgang wird.

Die mögliche Dauer des eigentlichen Eingriffs in die Steuerung, also die Dauer des Einschaltens des dritten MOSFET 60, wird über eine nicht dargestelltes ODER-Gatter mit einem vorgeschalteten Verzögerungsglied gesteuert. Ein High-Ausgang der Verzugszeitmessung oder des Verzögerungsgliedes führt dabei zu einem Einschalten des dritten MOSFETs 60. Das Verzögerungsglied kann beispielsweise ein RC-Glied und einen mit dem Knotenpunkt im Mittelpunkt des RC-Gliedes verbundenen Schmitt-Trigger aufweisen.

Wie aus der Darstellung der Funktionalität der Teilschaltung der Figur 5 ersichtlich, wird hier ein Vergleich der aktuell ermittelten Verzugszeit mit der jeweiligen vorherigen Verzugszeit durchgeführt. Es wird also nur ermittelt, ob die aktuelle Verzugszeit deutlich kürzer ist als die vorherige, was auf einen deutlich und sehr plötzlich erhöhten Kollektorstrom I_{C} hindeutet. Hierdurch werden zwar nur Änderungen erfasst und keine absoluten Werte. Vorteilhaft ist daran aber, dass eine Kalibrierung auf einen jeweiligen IGBT 10 entfällt und somit der Treiber 12 mit seinen Schaltungen aus den Figuren 4 und 5 nicht an den jeweiligen IGBT 10 angepasst werden muss. Auch die Temperatur als weitere erhebliche Einflussgröße muss nicht durch eine aufwändige Korrekturschaltung einbezogen werden, da diese sich in allen realen Fällen nur viel langsamer ändern als der Kollektorstrom I_{C}, so dass sie auf die Differenz der Verzugszeiten zwischen zwei Schaltvorgängen kaum Einfluss nimmt. Dadurch werden Aufbau und Einsatz der Schaltungen deutlich vereinfacht.

Mit der Verzugszeit wird eine Größe ermittelt, die also beeinflusst ist vom Kollektorstrom I_{C}, aber diesem nicht entspricht, weil sie noch durch andere erhebliche Einflussgrößen mitbestimmt wird. Eine alternative solche Größe zur Verzugszeit, die sich bei Messungen an IGBTs herausgestellt hat, ist der Gatestrom I_{G}.

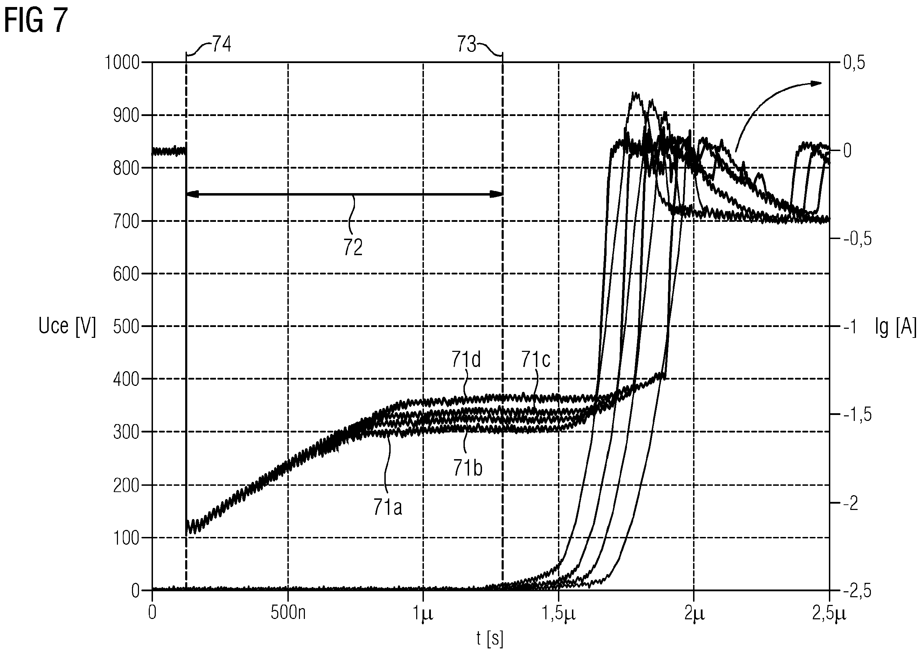

In einem zweiten Ausführungsbeispiel für die Erfindung führt der Treiber 12 daher eine alternative Messung durch. Diese Messung basiert auf der Erkenntnis, dass die Höhe des Gatestroms I_{G}, die sich nach dem Ablauf einer Messzeit 72 nach Beginn eines Abschaltvorgangs ergibt, von der Höhe des Kollektor-Stroms I_{C} abhängt. Dieser Zusammenhang ist in Figur 7 verdeutlicht. Figur 7 zeigt eine Messreihe zu Schaltvorgängen eines IGBT bei verschiedenen Werten für den Kollektor-Strom. Die Messkurven 71a...d zeigen den Verlauf des Gate-Stroms I_{G} während eines Abschaltvorgangs, der in etwa 2 µs dauert. Die Messkurve 71a ist bei einem Kollektor-Strom von I_{C} = 225 A aufgenommen und die Messkurve 71d bei einem Kollektor-Strom von I_{C} = 850 A. Die zugehörigen Verläufe 32a...d der Kollektor-Emitter-Spannung U_{CE} sind ebenfalls aufgetragen.

Zur realen Bestimmung des Gatestroms wird in einem Messzeitraum, auch Messfenster genannt, eine Integration des an einem Shunt-Widerstand gemessenen Stroms durchgeführt, also eine Ladungsmenge bestimmt. Dieses Messfenster wird an den verwendeten IGBT-Typ angepasst. Beispielsweise kann das Messfenster einen Zeitraum von 200 ns bis 300 ns nach dem Beginn des Abschaltvorgangs umfassen.

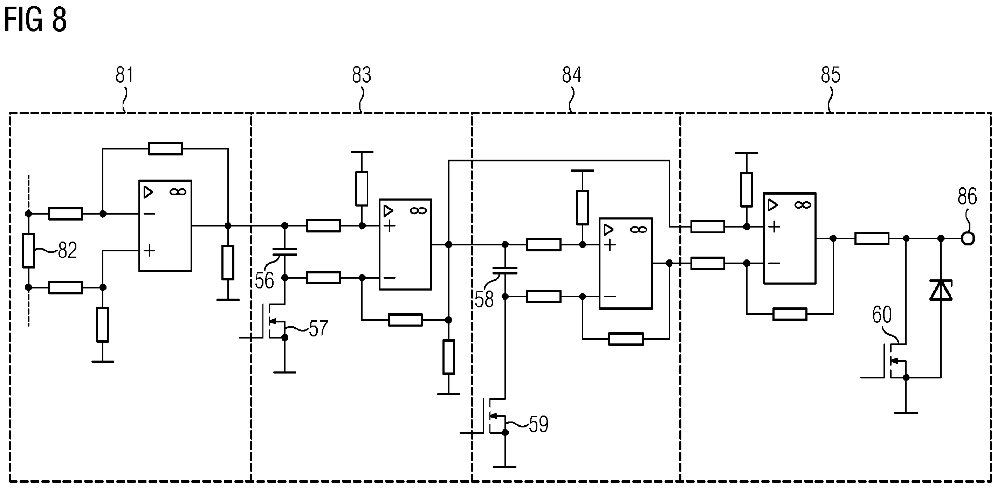

Der konkrete Zeitpunkt 73, zu dem die Messung durchgeführt wird, ergibt sich, indem nach dem Beginn des Abschaltvorgangs zum Zeitpunkt 74 die Messzeit verstreicht. In Figur 7 ist erkennbar, dass zu Anfang des Abschaltvorgangs die Verläufe 71a...d des Gate-Stroms noch nicht unterscheidbar sind, aber nach Ablauf der Messzeit zum Zeitpunkt 73 eine klare Abhängigkeit vom Kollektor-Strom I_{C} besteht. Die Verarbeitung des Gate-Stroms I_{G} kann in der Teilschaltung gemäß Figur 8 erfolgen. Wiederum ist diese Teilschaltung mit Operationsverstärkern aufgebaut, damit die einzelnen Funktionsblöcke gut erkennbar sind. In einer realen Schaltung würden diese typischerweise durch einfachere Halbleiterschalter ersetzt und der Aufbau vereinfacht und verkleinert.

Die Teilschaltung der Figur 8 lässt sich grob in vier Blöcke unterteilen. Ein erster Block 81 stellt dabei einen Differenzverstärker dar und umfasst einen Shuntwiderstand 82, der im Gatekreis angeordnet ist und zur Aufnahme des Gate-Stroms I_{G} dient.

Die folgenden Funktionsblöcke 83, 84, 85 stimmen weitgehend mit den Blöcken 53, 54, 55 der Figur 5 überein. Daher wird die Beschreibung ihrer Funktion hier nicht wiederholt. Im Ergebnis wird auch hier der aktuelle Gate-Strom I_{G} aufgenommen, mit dem vorherigen Gate-Strom verglichen und basierend auf dem Vergleich ein Impuls für die Endstufe des Treibers 12 abgeleitet, der am Ausgang 86 der Teilschaltung anliegt. Die in den Funktionsblöcken 83, 84, 85 verwendeten MOSFETs 57, 59, 60 entsprechen in Funktion und Anordnung denjenigen, die in Figur 5 verwendet werden. Die Ansteuerung erfolgt mit einer zeitlichen Abfolge, die derjenigen der Figur 6 entspricht.

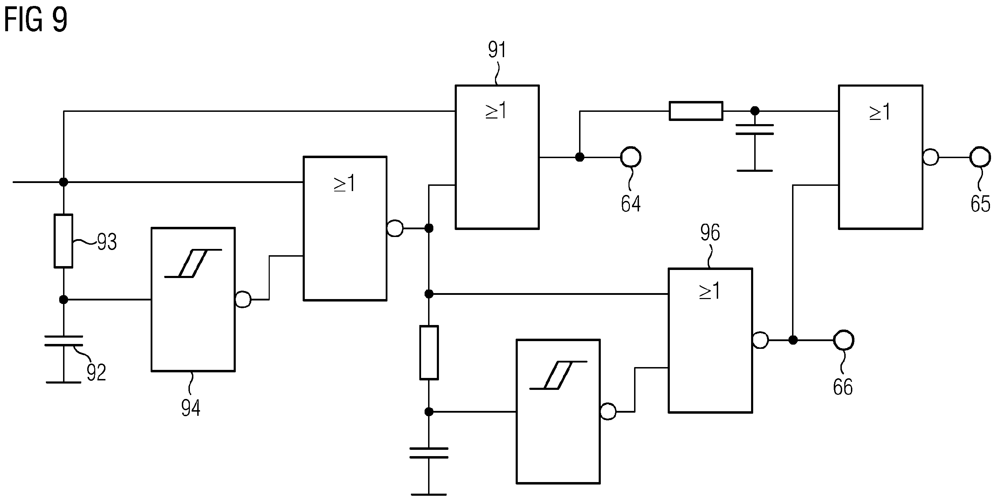

Figur 9 zeigt ein Blockschaltbild einer Schaltung, mit der die Schaltsignale 64, 65, 66 für die MOSFETs 57, 59, 60 erzeugt werden. Das OR-Gatter 91 schaltet dabei den ersten MOSFET 57 zumindest solange an, wie auch der IGBT 10 eingeschaltet ist. Über den Kondensator 92 und Widerstand 93 sowie den invertierenden Schmitt-Trigger 94 und das NOR-Gatter 95 wird der erste MOSFET 57 noch für eine Messzeitspanne nach dem Abschaltimpuls für den IGBT 10 angeschaltet gelassen. Ist diese Zeit abgelaufen, wird der Impuls für die Endstufe aktiviert durch Einschalten des dritten MOSFET 60 über das NOR-Gatter 96. Das NOR-Gatter 97 wiederum schaltet den zweiten MOSFET 59 ein, wenn die beiden anderen MOSFETs 57, 60 abgeschaltet sind.

In leichter Abwandlung wird diese Schaltung auch bei der Messung der Verzugszeit eingesetzt. Dabei ergibt sich die Abschaltung des ersten MOSFETs 57 aber aus dem Vergleich der Kollektor-Emitter-Spannung U_{CE} mit dem Schwellwert 33.

Wie man aus den Figuren 3 und 7 erkennen kann, ist der Zeitpunkt 34a...d, 73, zu dem eine Aussage über die Höhe des Kollektor-Stroms I_{C} in Form einer Änderung gegenüber einem vorherigen Abschaltvorgang vorliegt, vor den Zeitpunkten 24, 25, die mit einer dU_{CE}/dt oder dI_{C}/dt-Messung erreichbar sind. Es werden also gerade bei schnell abschaltenden IGBTs 10 mehrere 100 ns Zeit gewonnen, innerhalb denen eine Reaktion auf einen Überstrom erfolgen kann.

### Bezugszeichenliste

- 10: IGBT
- 11: Gate-Anschluss
- 12: Treiberschaltung
- 20: übergeordnete Steuerung
- 21: Verlauf der Kollektor-Emitter-Spannung
- 22: Verlauf des Kollektor-Stroms
- 23: Zeitpunkt des Auftretens einer Überspannung
- 24: Zeitpunkt der dI_{C}/dt-Messung
- 25: Zeitpunkt der dU_{CE}/dt-Messung
- 31a...d: Verlauf der Gate-Emitter-Spannung
- 32a...d: Verlauf der Kollektor-Emitter-Spannung
- 33: Schwellwert
- 34a...d: Zeitpunkte
- 41: AND-Gatter
- 42, 43: Komparatoren
- 44: Knotenpunkt
- 51...55: Funktionsblöcke
- 56, 58: Kondensator
- 57, 59, 60: MOSFET
- 61...65: Schaltzustände
- 71a...d: Verlauf des Gate-Stroms
- 72: Messzeit
- 73: Zeitpunkt
- 74: Beginn des Abschaltvorgangs
- 81, 83: Funktionsblöcke
- 82: Shunt-Widerstand
- 91: OR-Gatter
- 92: Kondensator
- 93: Widerstand
- 94: Schmitt-Trigger
- 96: NOR-Gatter

## Patentansprüche

1. Treiberschaltung (12) zur Ansteuerung eines Halbleiterschalters (10), umfassend einen Kontakt zur Verbindung mit einem Steueranschluss (11) des Halbleiterschalters (10) und eine Vorrichtung, die ausgestaltet ist, im Zuge eines Abschaltvorgangs des Halbleiterschalters (10) eine Messung eines von der Höhe des durch den Halbleiterschalter (10) fließenden Stroms abhängigen Werts vorzunehmen, wobei der Wert entweder die Höhe des Gatestroms (71a...d) zu einem Zeitpunkt (72) oder in einem Zeitfenster nach Beginn (74) des Abschaltvorgangs oder eine Zeitspanne vom Beginn (74) des Abschaltvorgangs bis zum Erreichen eines festlegbaren Schwellwerts (33) der über den Halbleiterschalter (10) abfallenden Spannung ist, und in Abhängigkeit von der Größe des Werts eine Steuermaßnahme zur Verringerung der zeitlichen Änderung des durch den Halbleiterschalter (10) fließenden Stroms vorzunehmen, **dadurch gekennzeichnet, dass** die Vorrichtung ausgestaltet ist, den Beginn (74) eines Abschaltvorgangs anhand eines Schwellwerts für die Gatespannung festzulegen oder anhand eines Steuerbefehls der übergeordneten Steuerung (20) festzulegen oder anhand des Werts einer Steuerspannung festzulegen, wobei die Steuerspannung ein Spannungswert zwischen einer Endstufe der Treiberschaltung (12) und einem Gatewiderstand ist.

2. Treiberschaltung (12) nach Anspruch 1, bei der die Vorrichtung ausgestaltet ist, als Steuermaßnahme ein temporäres Wiedereinschalten des Halbleiterschalters (10) vorzunehmen.

3. Treiberschaltung (12) nach Anspruch 1, bei der die Vorrichtung ausgestaltet ist, als Steuermaßnahme eine Änderung der Gatespannung vorzunehmen.

4. Treiberschaltung (12) nach Anspruch 1, bei der die Vorrichtung ausgestaltet ist, als Steuermaßnahme ein Umschalten auf einen höheren Gatewiderstand vorzunehmen.

5. Treiberschaltung (12) nach einem der vorangehenden Ansprüche, bei der die Vorrichtung ausgestaltet ist, in Abhängigkeit von der Größe des Werts ein Signal an eine übergeordnete Steuerung (20) zu geben.

6. Treiberschaltung (12) nach einem der vorangehenden Ansprüche, bei der die Vorrichtung ausgestaltet ist, bei einem ersten Abschaltvorgang den gemessenen Wert zu speichern und bei einem folgenden Abschaltvorgang, insbesondere dem nächstfolgenden Abschaltvorgang, eine Differenz des in dem folgenden Abschaltvorgang gemessenen Werts und des gespeicherten Werts zu ermitteln und die Steuermaßnahme basierend auf der Differenz zu steuern.

7. Treiberschaltung (12) nach einem der vorangehenden Ansprüche, bei der die Vorrichtung ausgestaltet ist, unter Verwendung einer gespeicherten Wertetabelle aus dem gemessenen Wert einen Ergebniswert zu ermitteln und basierend auf dem Ergebniswert die Steuermaßnahme zu steuern.

8. Treiberschaltung (12) nach einem der vorangehenden Ansprüche, bei der die Vorrichtung ausgestaltet ist, als Schwellwert (33) der Kollektor-Emitter-Spannung höchstens 10% der Nennspannung des Halbleiterschalters (10) zu verwenden.

9. Treiberschaltung (12) nach einem der vorangehenden Ansprüche, bei der die Vorrichtung ausgestaltet ist, einen Zeitraum, in dem die Vornahme der Steuermaßnahme möglich ist, mittels einer Verzögerungsschaltung festzulegen.

10. Treiberschaltung (12) nach einem der vorangehenden Ansprüche, bei der die Vorrichtung ausgestaltet ist, einen Zeitraum, in dem die Vornahme der Steuermaßnahme möglich ist, mittels einer Spannungsmessung an einer Z-Diode festzulegen, die mittels eines Spannungsteilers an die Kollektor-Emitter-Spannung angeschlossen ist.

11. Halbleiterschalter (10), insbesondere IGBT (10), MOSFET oder SiC-basierter MOSFET, mit einer Treiberschaltung (12) nach einem der vorangehenden Ansprüche.

12. Verfahren zur Ansteuerung eines Halbleiterschalters (10), bei dem im Zuge eines Abschaltvorgangs des Halbleiterschalters (10) eine Messung eines von der Höhe des durch den Schalter fließenden Stroms abhängigen Werts vorgenommen wird, wobei der Wert entweder die Höhe des Gatestroms (71a...d) zu einem Zeitpunkt (72) nach Beginn (74) des Abschaltvorgangs oder eine Zeitspanne vom Beginn (74) des Abschaltvorgangs bis zum Erreichen eines festlegbaren Schwellwerts (33) der über den Schalter abfallenden Spannung ist und in Abhängigkeit von der Größe des Werts eine Steuermaßnahme zur Verringerung der zeitlichen Änderung des durch den Halbleiterschalter (10) fließenden Stroms vorgenommen wird, **dadurch gekennzeichnet, dass** der Beginn (74) eines Abschaltvorgangs anhand eines Schwellwerts für die Gatespannung festgelegt wird oder anhand eines Steuerbefehls der übergeordneten Steuerung (20) festgelegt wird oder anhand des Werts einer Steuerspannung festgelegt wird, wobei die Steuerspannung ein Spannungswert zwischen einer Endstufe der Treiberschaltung (12) und einem Gatewiderstand ist.

## Claims

1. Driver circuit (12) for controlling a semiconductor switch (10), comprising a contact for connection to a control terminal (11) of the semiconductor switch (10) and a device that is designed in the course of a switch-off process of the semiconductor switch (10) to carry out a measurement of a value dependent on the level of the current flowing through the semiconductor switch (10), wherein the value is either the level of the gate current (71a...d) at a point in time (72) or in a time window after the start (74) of the switch-off process or a timespan from the start (74) of the switch-off process until a definable threshold value (33) of the voltage drop across the semiconductor switch (10) is reached, and depending on the size of the value, a control measure to reduce the change over time in the current flowing through the semiconductor switch (10), **characterised in that** the device is designed to define the start (74) of a switch-off process using a threshold value for the gate voltage or using a control command from the higher-level controller (20) or based on the value of a control voltage, wherein the control voltage is a voltage value between an output stage of the driver circuit (12) and a gate resistor.

2. Driver circuit (12) according to claim 1, in which the device is designed to temporarily switch the semiconductor (10) back on as a control measure.

3. Driver circuit (12) according to claim 1, in which the device is designed to change the gate voltage as a control measure.

4. Driver circuit (12) according to claim 1, in which the device can be designed to switch to a higher gate resistance as a control measure.

5. Driver circuit (12) according to one of the preceding claims, in which the device is designed to give a signal to a higher-level controller (20) depending on the magnitude of the value.

6. Driver circuit (12) according to one of the preceding claims, in which the device is designed to store the measured value during a first switch-off process and to determine a difference between the value measured in the subsequent switch-off process and the stored value during a subsequent switch-off process, in particular the next switch-off process, and to control the control measure based on the difference.

7. Driver circuit (12) according to one of the preceding claims, in which the device is designed to determine a result value from the measured value using a stored value table and to control the control measure based on the result value.

8. Driver circuit (12) according to one of the preceding claims, in which the device is designed to use at most 10% of the nominal voltage of the semiconductor switch (10) as a threshold value (33) of the collector-emitter voltage.

9. Driver circuit (12) according to one of the preceding claims, in which the device is designed to define a time in which it is possible to carry out the control measure by means of a delay circuit.

10. Driver circuit (12) according to one of the preceding claims, in which the device is designed to set a time in which the implementation of the control measure is possible, determined by means of a voltage measurement at a Z-diode, which is connected to the collector-emitter voltage by means of a voltage divider.

11. Semiconductor switch (10), in particular IGBT (10), MOSFET or SiC-based MOSFET, with a driver circuit (12) according to one of the preceding claims.

12. Method for controlling a semiconductor switch (10), in which a measurement of a value dependent on the level of the current flowing through the switch is carried out during the course of a switch-off process of the semiconductor switch (10), wherein the value is either the level of the gate current (71a...d) at a point in time (72) after the start (74) of the switch-off process or a timespan from the start (74) of the switch-off process until a definable threshold value (33) of the voltage drop across the switch is reached and depending on the size of the value, a control measure is taken to reduce the change over time in the current flowing through the semiconductor switch (10), **characterised in that** the start (74) of a switch-off process is defined using a threshold value for the gate voltage or using a control command from the higher-level controller (20) or based on the value of a control voltage, wherein the control voltage is a voltage value between an output stage of the driver circuit (12) and a gate resistor.

## Revendications

1. Circuit (12) d'attaque pour la commande d'un interrupteur (10) à semiconducteur, comprenant un contact de liaison à une borne (11) de commande de l'interrupteur (10) à semiconducteur et un dispositif, qui est conformé pour effectuer, au cours d'une opération d'ouverture de l'interrupteur (10) à semiconducteur, une mesure d'une valeur, qui dépend du niveau du courant passant dans l'interrupteur (10) à semiconducteur, dans lequel la valeur est ou bien le niveau du courant (71a...d) de grille à un instant (72) ou dans un créneau temporel après le début (74) de l'opération d'ouverture ou bien un laps de temps allant du début (74) de l'opération d'ouverture jusqu'à que soit atteinte une valeur (33) de seuil pouvant être déterminée de la tension chutant aux bornes de l'interrupteur (10) à semiconducteur et, en fonction de la grandeur de la valeur, est prise une mesure de commande pour diminuer la variation en fonction du temps du courant passant dans l'interrupteur (10) à semiconducteur, **caractérisé en ce que** le dispositif est conformé pour déterminer le début (74) d'une opération d'ouverture, à l'aide d'une valeur de seuil de la tension de grille ou pour le déterminer, à l'aide d'une instruction de la commande (20) supérieure hiérarchiquement ou pour le déterminer à l'aide de la valeur d'une tension de commande, dans lequel la tension de commande est une valeur de la tension entre un étage final du circuit (12) d'attaque et une résistance de grille.

2. Circuit (12) d'attaque suivant la revendication 1, dans lequel le dispositif est conformé pour prendre, comme mesure de commande, une refermeture temporaire de l'interrupteur (10) à semiconducteur.

3. Circuit (12) d'attaque suivant la revendication 1, dans lequel le dispositif est conformé pour prendre, comme mesure de commande, une variation de la tension de grille.

4. Circuit (12) d'attaque suivant la revendication 1, dans lequel le dispositif est conformé pour prendre, comme mesure de commande, une commutation sur une résistance de grille plus grande.

5. Circuit (12) d'attaque suivant l'une des revendications précédentes, dans lequel le dispositif est conformé pour, en fonction de la grandeur de la valeur, donner un signal à une commande (20) supérieure hiérarchiquement.

6. Circuit (12) d'attaque suivant l'une des revendications précédentes, dans lequel le dispositif est conformé pour mettre, lors d'une première opération d'ouverture, la valeur mesurée en mémoire et pour, lors d'une opération d'ouverture suivante, en particulier lors de l'opération d'ouverture venant immédiatement ensuite, déterminer une différence entre la valeur mesurée dans l'opération d'ouverture suivante et la valeur mise en mémoire et prendre la mesure de commande sur la base de la différence.

7. Circuit (12) d'attaque suivant l'une des revendications précédentes, dans lequel le dispositif est conformé pour, en utilisant une table de valeurs mise en mémoire, déterminer, à partir de la valeur mesurée, une valeur de résultat et prendre la mesure de commande sur la base de la valeur de résultat.

8. Circuit (12) d'attaque suivant l'une des revendications précédentes, dans lequel le dispositif est conformé pour utiliser, comme valeur (33) de seuil de la tension collecteur-émetteur au plus 10 % de la tension nominale de l'interrupteur (10) à semiconducteur.

9. Circuit (12) d'attaque suivant l'une des revendications précédentes, dans lequel le dispositif est conformé pour déterminer, au moyen d'un circuit de temporisation, un laps de temps, dans lequel la prise de la mesure de commande est possible.

10. Circuit (12) d'attaque suivant l'une des revendications précédentes, dans lequel le dispositif est conformé pour déterminer un laps de temps, dans lequel la prise de la mesure de commande est possible, au moyen d'une mesure de tension sur une diode Z, laquelle est connectée à la tension collecteur-émetteur au moyen d'un diviseur de tension.

11. Interrupteur (10) à semiconducteur, notamment IGBT (10), MOSFET ou MOSFET à base de SiC, comprenant un circuit (12) d'attaque suivant l'une des revendications précédentes.

12. Procédé de commande d'un interrupteur (10) à semiconducteur, dans lequel on effectue, au cours d'une opération d'ouverture de l'interrupteur (10) à semiconducteur, une mesure d'une valeur, qui dépend du niveau du courant passant dans l'interrupteur, dans lequel la valeur est ou bien le niveau du courant (71a...d) de grille à un instant (72) ou dans un créneau temporel après le début (74) de l'opération d'ouverture ou bien un laps de temps allant du début (74) de l'opération d'ouverture jusqu'à que soit atteinte une valeur (33) de seuil pouvant être déterminée de la tension chutant aux bornes de l'interrupteur à semiconducteur et, en fonction de la grandeur de la valeur, on prend une mesure de commande pour diminuer la variation en fonction du temps du courant passant dans l'interrupteur (10) à semiconducteur, **caractérisé en ce que** l'on détermine le début (74) d'une opération d'ouverture, à l'aide d'une valeur de seuil de la tension de grille ou on le détermine à l'aide d'une instruction de commande de la commande (20) supérieure hiérarchiquement ou on le détermine à l'aide de la valeur d'une tension de commande, dans lequel la tension de commande est une valeur de tension entre un étage final du circuit (12) d'attaque et une résistance de grille.
